# EUROPEAN PATENT APPLICATION

(11) **EP 4 422 023 A1**
(43) Date of publication of application: **28.08.2024**
(21) Application number: 23206209.1
(22) Date of filing: 26.10.2023
(51) Int. Cl.: H02J 7/00, H02H 3/02, H02H 7/18, H02H 7/22, H02H 11/00

(54) **SWITCH CONTROL DEVICE AND BATTERY PACK INCLUDING THE SAME**

(30) Priority: 22.02.2023 KR 20230023771
(71) Applicant: Samsung SDI Co., Ltd., Yongin-si, Gyeonggi-do 17084 (KR)
(72) Inventor: CHO, Kyusung, 17084 Yongin-si (KR)
(74) Representative: Marks & Clerk LLP

(57) **Abstract**

A switch control device according to the present disclosure may include a controller configured to output a control signal to control an opening/closing of a switch; a low voltage protective circuit configured to generate an off signal indicating the opening state of the switch when a voltage of the battery module is lower than a predetermined value in a state that the control signal indicates a closing state of the switch, and to maintain the output of the off signal until the control signal indicates the opening state of the switch; and a switch driver that controls the opening/closing of the switch according to the control signal and the off signal and controls the switch in an opening state regardless of the control signal when the off signal is received from the low voltage protective circuit.

## Description

### BACKGROUND OF THE DISCLOSURE

### (a) Field of the Disclosure

The present disclosure relates to a switch control device and a battery pack including the same.

### (b) Description of the Related Art

Recently, according to strengthening of environmental regulations including CO2 regulations, interest in environmentally-friendly vehicles has been increasing. Accordingly, vehicle companies have been actively researching and developing pure electrical vehicles and hydrogen vehicles as well as hybrid and plug-in hybrid vehicles.

A high voltage battery for storing electrical energy obtained from various energy sources is applied to the environmentally-friendly vehicles. A high voltage storage system of a vehicle uses high voltage electrical energy supplied from a high voltage battery for driving or electrical needs of the vehicle.

In the high voltage battery pack, the output of the high voltage battery pack may be transmitted to a load or cut off by a high voltage switch such as a relay or a contactor. When the battery pack is aged, a transient situation may occur in which the battery voltage of the battery pack momentarily decreases and then rises again. When such a transient situation occurs, the high voltage switch operated by the battery voltage fails to maintain the closed state and opens and then becomes short-circuited again, and this misoperation may cause a welding of the switch.

### SUMMARY OF THE DISCLOSURE

A technical object to be solved through present disclosure is to provide a switch control device for improving a contact welding of a switch, and a battery pack including the same.

A switch control device according to the present disclosure may include a controller configured to output a control signal to control an opening/closing of a switch; a low voltage protective circuit configured to generate an off signal indicating an opening state of the switch when a voltage of a battery module is lower than a predetermined value in a state that the control signal indicates a closing state of the switch, and to maintain an output of the off signal until the control signal indicates the opening state of the switch; and a switch driver configured to control the opening/closing of the switch according to the control signal and the off signal, and to control the switch in an opening state regardless of the control signal when the off signal is received from the low voltage protective circuit.

The low voltage protective circuit may be further configured to block the output of the off signal when the control signal indicates the opening state of the switch.

The low voltage protective circuit may include a comparison voltage generation circuit configured to supply one of a first comparison voltage corresponding to the voltage of the battery module and a second comparison voltage that maintains a fixed value regardless of the voltage of the battery module to a first node depending on the control signal; a reference voltage generation circuit configured to supply a reference voltage to the second node; and a comparison circuit configured to control the output of the off signal according to a result of comparing a voltage of the first node and the voltage of the second node.

The comparison voltage generation circuit may be further configured to supply the first comparison voltage to the first node when the control signal indicates the closing state of the switch, and to supply the second comparison voltage to the first node when the control signal indicates the opening state of the switch,

The second comparison voltage may be higher than the reference voltage. The first comparison voltage may be lower than the reference voltage when the voltage of the battery module is lower than the predetermined value, and higher than the reference voltage when the voltage of the battery module is higher than the predetermined value.

The comparison circuit may be configured to control the off signal to be output to the switch driver when the first comparison voltage is lower than the reference voltage while the first comparison voltage is being supplied to the first node, and to maintain the output of the off signal until the second comparison voltage is supplied to the first node.

The comparison circuit may be further configured to block the output of the off signal while the second comparison voltage is supplied to the first node.

The comparison circuit may be configured to output an activation signal of high level so as to output the off signal when the first comparison voltage is lower than the reference voltage while the first comparison voltage is supplied to the first node.

The comparison circuit may be configured to output a deactivation signal of low level so as to block the output of the off signal when the first comparison voltage is supplied to the first node, the first comparison voltage is higher than the reference voltage, and before the activation signal is output.

The comparison circuit may be configured to output the deactivation signal so as to block the output of the off signal when the second comparison voltage is supplied to the first node.

The comparison circuit may be configured to transmit the voltage generated from the output of the comparison circuit to the second node, and when the comparison circuit outputs the activation signal, the voltage transmitted from the output of the comparison circuit to the second node may be higher than the first comparison voltage and lower than the second comparison voltage.

The comparison voltage generation circuit may include a first transistor including a first terminal, a second terminal connected to a ground, and a control terminal to which a control signal is applied, a first resistor connected between a first power node to which the voltage of the battery module is applied and the first node; and a second resistor connected between the first node and the first terminal of the first transistor. The first transistor may be turned off when the control signal indicates the opening state of the switch, and turned on when the control signal indicates the closing state of the switch. When the first transistor is turned on, the first comparison voltage distributed from the voltage of the battery module by the first and second resistors may be supplied to the first node.

The comparison voltage generation circuit may further include a first diode including an anode connected to the first node and a cathode connected to a second power node. When the first transistor is turned off, the second comparison voltage may be supplied to the first node by the first diode.

The second comparison voltage may be the voltage clamped from the voltage of the second power node by the first diode and higher than the first comparison voltage.

The first transistor may be an N-channel MOSFET(Metal Oxide Semiconductor Field Effect Transistor).

The reference voltage generation circuit may include a third resistor connected between the second power node and the second node, and a fourth resistor connected between the second power node and a ground.

The comparison circuit may include a comparator including input terminals respectively connected to the first node and the second node, and an output terminal outputting an output signal corresponding to a result of comparing the voltage of the first node and the voltage of the second node, and a second diode including an anode connected to the output terminal of the comparator and a cathode connected to the second node. The comparison circuit, when the output signal of high level is output to the output terminal of the comparator, may be configured to transfer the voltage generated from the output signal of high level to the second node through the second diode.

The voltage generated from the output signal of high level may be higher than the first comparison voltage and the reference voltage, and lower than the second comparison voltage.

The low voltage protective circuit may further include an off circuit configured to output the off signal to the switch driver according to the output signal of the comparison circuit.

The off circuit may include a second transistor including a control terminal into which the output signal of the comparator is input, a first terminal connected to an input terminal of the switch driver, and a second terminal connected to a ground. The second transistor may connect the ground and the input terminal of the switch driver so that the off signal is transmitted to the input terminal of the switch driver during the turning-on.

The second transistor may be an NPN transistor.

The switch control device may further include a fifth resistor connected between an output terminal of the controller and the input terminal of the switch driver.

A battery pack according to an embodiment may a battery module; a switch configured to control the electrical connection between the battery module and the load; and the switch control device above-described wherein the opening/closing of the switch may controlled by the switch control device.

According to the present disclosure, it is possible to prevent the contact points of the switch from being welled by blocking the switching of the switch back to the closing state in a transient situation.

At least some of the above features that accord with the invention and other features according to the invention are set out in the claims.

### BRIEF DESCRIPTION OF THE DRAWINGS

FIG. 1 is a view schematically showing a switch control device according to an embodiment.
FIG. 2 is a view showing an example of a circuit configuration of a switch control device according to an embodiment.
FIG. 3 is a view schematically showing an operation timing diagram of a switch control device according to an embodiment.
FIG. 4 is a view schematically showing a battery pack including a switch control device according to an embodiment.

### DETAILED DESCRIPTION OF THE EMBODIMENTS

Hereinafter, embodiments of the present invention are described in detail with reference to the accompanying drawings. Hereinafter, the description describes effects and features of the embodiments and a method for implementing the same in detail with reference to the accompanying drawings. The same reference numerals denote the same elements in the drawings, and overlapping descriptions thereof are omitted. However, the present invention may be implemented in various forms and should not be construed as being limited to the embodiments described herein. Rather, these embodiments are provided as examples to convey the aspects and features of the present invention to those skilled in the art.

Accordingly, the description may not describe any processes, elements or techniques deemed not necessary to those skilled in the art for understanding of the aspects and features of the present invention. The drawings may exaggeratedly show relative sizes of elements, layers and regions for clarity.

Term "and/or" in this specification may include all combinations or any combination of a plurality of related listed items. Usage of "may" or "may be" in describing the embodiments of the present invention may indicate "may" or "may be" in "one or more embodiments of the present invention.". In the following description of the embodiments of the present invention, a term in a singular form may include its plural form unless the context clearly indicates otherwise.

In this specification, terms including ordinal numbers such as "first," "second," "third" and the like are used to describe various components. However, these components are not limited by these terms. These terms are used only to distinguish one component from another component. For example, a 'first' component may be named a 'second' component and the 'second' component may also be similarly named the 'first' component, without departing from the scope of the present invention.

In this specification, when one component or layer is described as being "on, " "connected to, " or "coupled to" another component or layer, it may be "directly on" another component or layer or "connected to" and "coupled to" another component or layer interposing one or more other components or layers. In addition, when a component or layer is described as being "between" two components or layers, it should be understood as only one component or layer between the two components or layers, or one or more other components or layers interposed between the same.

In this specification, a case where two components are electrically connected to each other may not only include a case where the two components are directly connected to each other, but also include a case where the two components are connected to each other through another component. Another component may include a switch, a resistor, a capacitor or the like. In describing the embodiments, an expression "to connect" may indicate "to electrically connect" when there is no expression "to directly connect.".

Hereinafter, a switch control device, and a battery pack including the same according to an embodiment will be described in detail with reference to necessary drawings

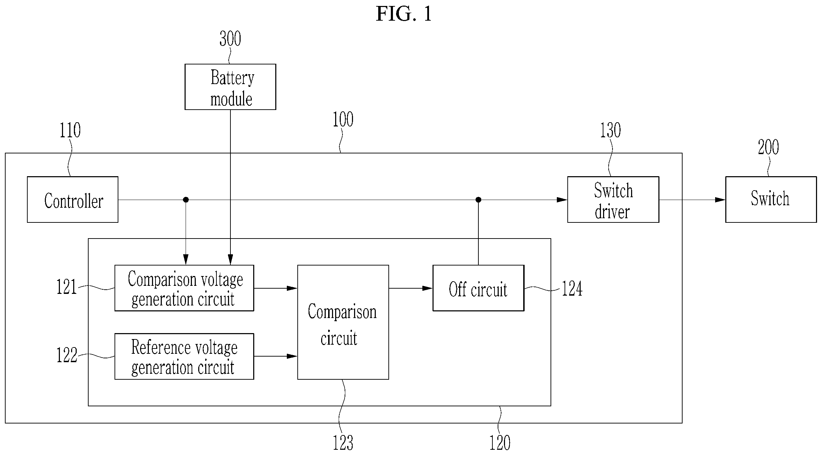

FIG. 1 is a view schematically showing a switch control device according to an embodiment.

Referring to FIG. 1, a switch control device 100 may include a controller 110, a low voltage protective circuit 120, and a switch driver 130.

The controller 110 may determine whether the switch 200 is opening/closing, and output a control signal for controlling the switch 200. For example, the controller 110 may output a high level control signal to turn on (close) the switch 200 and a low level control signal to turn off (open) the switch 200. In this disclosure, the high level and the low level may indicate a voltage level higher than a corresponding voltage and a voltage level lower than a corresponding voltage, respectively, based on a predetermined voltage. For example, the high level may represent an operation voltage (e.g., 5V) of the controller 110 or a voltage close to the operation voltage, and the low level may represent a ground voltage 0V or a voltage close to the ground voltage.

The low voltage protective circuit 120 may receive a control signal from the controller 110. The low voltage protective circuit 120 may receive a voltage of the battery module 300 from the battery module 300 as an input. The battery module 300 may operate as a voltage source supplying an operation voltage to the switch 200. The low voltage protective circuit 120 may monitor the voltage of the battery module 300 while the received control signal indicates the turned on (closed) state of the switch 200, and continuously output the off signal to the switch driver 130 if the voltage of the battery module 300 drops below a predetermined value. The low voltage protective circuit 120 may block the output of the off signal if the received control signal indicates the off (opened) state of the switch 200.

The low voltage protective circuit 120 may include a comparison voltage generation circuit 121, a reference voltage generation circuit 122, a comparison circuit 123, and an off circuit 124.

The comparison voltage generation circuit 121 may receive the control signal from the controller 110 and output a comparison voltage generated according to the received control signal to the comparison circuit 123 described later. The comparison voltage generation circuit 121, if the control signal indicates the turned on (closed) state of the switch 200 (i.e., if the level of the control signal is high level), may output a voltage (hereinafter referred to as 'a first comparison voltage') whose a voltage value is determined according to the output voltage of the battery module 300 as a comparison voltage. The comparison voltage generation circuit 121, if the control signal indicates the turned off (open) state of the switch 200 (i.e., if the level of the control signal is low level), output a voltage (hereinafter referred to as 'a second comparison voltage') having a fixed voltage value regardless of the output voltage of the battery module 300 as a comparison voltage.

The reference voltage generation circuit 122 may output a reference voltage to the comparison circuit 123 described below.

The comparison circuit 123 may receive the comparison voltage and the reference voltage from the comparison voltage generation circuit 121 and the reference voltage generation circuit 122, respectively. The comparison circuit 123 may compare the comparison voltage and the reference voltage, and control the activation of the off circuit 124 described later according to the comparison result. For example, the comparison circuit 123 receives the first comparison voltage from the comparison voltage generation circuit 121 and if the first comparison voltage is lower than the reference voltage, may output the activation signal for activating the off circuit 124 described later to the off circuit 124. Also, for example, the comparison circuit 123, if the first comparison voltage is received from the comparison voltage generation circuit 121 and the first comparison voltage remains higher state than the reference voltage, may output the activation signal for deactivating the off circuit 124 described later to the off circuit 124. In addition, for example, the comparison circuit 123 may output the activation signal for deactivating the off circuit 124 described below to the off circuit 124 if the second comparison voltage is received from the comparison voltage generation circuit 121.

The comparison circuit 123 may further perform a latch function. If the activation signal is output from the comparison circuit 123 while the first comparison voltage is received, the comparison circuit 123 may maintain the output of the activation signal regardless of the voltage level of the first comparison voltage received thereafter. Then, if the second comparison voltage is received from the comparison voltage generation circuit 121, the comparison circuit 123 may stop outputting the activation signal and output the deactivation signal to the off circuit 124.

The off circuit 124 may activate or deactivate the output of the off signal according to the signal output from the comparison circuit 123. The off circuit 124 may output the off signal to the switch driver 130 if the activation signal is received from the comparison circuit 123. The off circuit 124 may stop outputting the off signal if the deactivation signal is received from the comparison circuit 123.

The switch driver 130 may control the switch 200 (e.g., a contactor, a relay, a transistor, etc.) to be turned on (closed) or turned off (opened) state according to the control signal received from the controller 110. For example, the switch driver 130 may control the switch 200 to be in the turned on (closed) state if the control signal is at a high level, and control the switch 200 to be in turned off (opened) state if the control signal is at a low level.

The switch driver 130 may control the switch 200 to be in the turned off (opened) state regardless of the control signal received from the controller 110 while the off signal is received from the low voltage protective circuit 120.

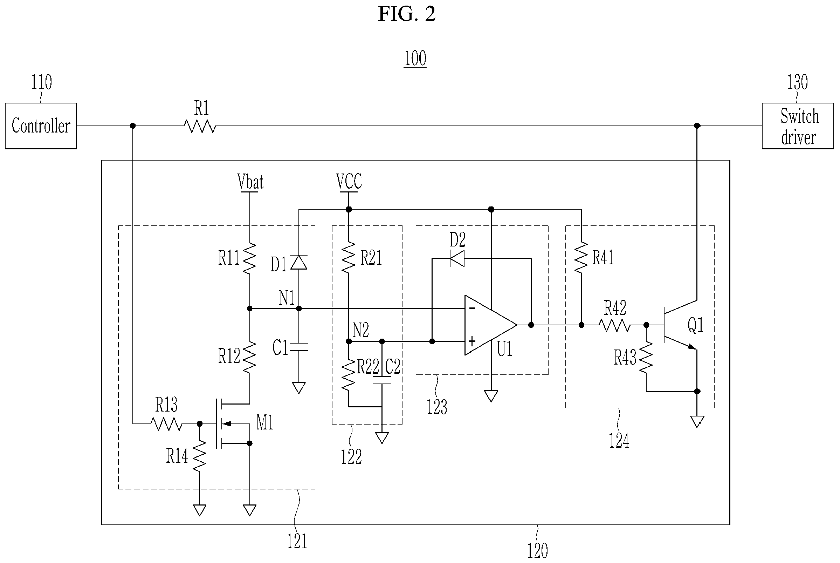

FIG. 2 is a view showing an example of a circuit configuration of the switch control device 100 according to an embodiment.

Referring to FIG. 2, the comparison voltage generation circuit 121 may include a transistor M1 connected to a ground, voltage distribution circuits R11 and R12 connected between the transistor M1 and a first power node Vbat, and a diode D1 connected between the node N1 and a second power node, VCC.

The transistor M1 may include a first terminal connected to a resistor R12 of the voltage distribution circuit, a second terminal connected to the ground, and a control terminal connected to the output terminal of the controller 110. The resistor R11 of the voltage distribution circuit may be connected between the first power node, Vbat, and a node N1, and the resistor R12 may be connected between the node N1 and the first terminal of transistor M1. The diode D1 may include an anode connected to the node N1 and a cathode connected to the second power node, VCC. The first power node, Vbat, may be connected to a positive terminal of the battery module 300, and the second power node, VCC, may be connected to a voltage source supplying the operation voltage to the controller 110 and a comparator U1 described later. Accordingly, the output voltage of the battery module 300 may be supplied to the first power node, Vbat, and the operation voltage (e.g., 5V) of the comparator U1 may be supplied to the second power node, VCC.

The comparison voltage generation circuit 121 may further include resistors R13 and R14 connected to the control terminal of the transistor M1 for the stable operation of the transistor M1. The comparison voltage generation circuit 121 may further include a capacitor C1 connected between the node N1 and the ground so that the voltage is stably supplied to the node N1.

The transistor M1 may be turned on or turned off according to the control signal received from the controller 110. The transistor M1 may be an N-channel metal oxide semiconductor field effect transistor (an N-channel MOSFET) of which the control terminal is a gate terminal, and the first terminal and the second terminal are a drain terminal and a source terminal, respectively. Therefore, the transistor M1 may be turned on if a voltage higher than a predetermined voltage is applied to the control terminal, and turned off if a voltage lower than a predetermined voltage is applied to the control terminal. That is, the transistor M1 may be turned on if the control signal is at a high level and turned off if the control signal is at a low level.

If the transistor M1 is turned on, the voltage distribution circuits R11 and R12 may be electrically connected to the ground through the transistor M1. Therefore, if the transistor M1 is turned on, the resistors R11 and R12 may supply the voltage (the first comparison voltage) divided from the voltage of the first power node, Vbat, that is, the output voltage of the battery module 300, to the node N1. On the other hand, if the transistor M1 is turned off, the voltage (the second comparison voltage) clamped from the voltage of the second power node, VCC, may be supplied to the node N1 by the resistor R11 and the diode D1 connected between the first power node, Vbat, and the second power node, VCC.

The reference voltage generation circuit 122 may include voltage distribution circuits R21 and R22 connected between the second power node, VCC, and the ground.

The resistor R21 may be connected between the second power node, VCC, and the node N2, and the resistor R22 may be connected between the node N2 and the ground. Accordingly, the resistors R21 and R22 may supply the voltage (the reference voltage) divided from the voltage of the second power node, VCC, that is, the operation voltage of the comparator U1, to the node N2. The values of the resistors R21 and R22 may be set so that the reference voltage may be used to detect even over-discharge conditions as well as transient conditions. That is, the voltage value of the reference voltage may be set by the resistors R21 and R22 so that not only the transient state of the battery module 300 but also the over-discharge state of the battery module 300 may be detected in the comparison circuit 123 described later.

The reference voltage generation circuit 122 may further include a capacitor C2 connected between node N2 and ground so that the voltage is stably supplied to the node N2.

The comparison circuit 123 may include a latch circuit including a comparator U1 and a diode D2.

The comparator U1 may include input terminals respectively connected to the nodes N1 and N2, and an output terminal connected to the off circuit 124. The diode D2 may include an anode connected to the output terminal of comparator U1 and a cathode connected to node N2.

The comparator U1 may compare the voltage at the node N1 with the voltage at the node N2, and determine the level of the output signal output to the off circuit 124 according to the comparison result. For example, the comparator U1 may have a negative input terminal connected to the node N1 and a positive input terminal connected to the node N2. In this case, if the voltage at node N2 is higher than the voltage at the node N1, the comparator U1 may output the output signal of high level (e.g., 5V), if the voltage at node N2 is lower than the voltage at node N1, the comparator U1 may output the output signa of low level (e.g., 0V). At this time, the output signal of high level operates as the activation signal for activating the off signal output of the off circuit 124, and the output signal of low level operates as the deactivation signal for inactivating the off signal output of the off circuit 124. In other words, if the activation signal is at a high level, it causes the activation of the off circuit, and if the actiation signal is at a low level, then it causes the deactivation of the off circuit. If the output signal (the activation signal) of high level is output from the comparator U1, the diode D2 transfers it to the node N2 so that the voltage of the node N2 may remain with the state higher than the voltage of the node N1. Accordingly, the comparator U1 may maintain the output of the output signal (the activation signal) of high level.

In a state where the transistor M1 of the comparison voltage generation circuit 121 is turned off, the second comparison voltage higher than the voltage of the second power node, VCC, may be applied to the node N1 by the diode D1 regardless of the voltage of the battery module 300. Also, since the reference voltage applied to the node N2 by the reference voltage generation circuit 122 is a voltage divided from the voltage of the second power node, VCC, it may be a lower voltage than the voltage of the node N1. In addition, since the signal output of high level from the comparator U1 corresponds to the voltage of the second power node, VCC, the voltage supplied to the node N2 by the diode D2 is higher than the voltage supplied to the node N2 by the voltage distribution circuits R21 and R22, but It may be lower than the second comparison voltage. Therefore, while the control signal indicates the turned off (opened) state of the switch 200 and the transistor M1 is turned off, regardless of the voltage of the battery module 300, the second comparison voltage applied to node N1 is higher than the voltage of node N2, so the comparator U1 may output the signal (the deactivation signal) of low level.

In the state that the transistor M1 of the comparison voltage generation circuit 121 is turned on, the first comparison voltage distributed from the output voltage of the battery module 300 by the voltage distribution circuits R11 and R12 may be supplied to the node N1. The resistance values of the resistors R11 and R12 may be set so that if the output voltage of the battery module 300 is a threshold value or more, the first comparison voltage is higher than the reference voltage generated by the resistors R21 and R22 and lower than the voltage delivered to the node N2 from the output of high level output from the comparator U1 through the diode D2. In addition, the resistance values of the resistors R11 and R12 may be set so that if the output voltage of the battery module 300 is lower than the threshold value, the first comparison voltage is lower than the reference voltage generated by the resistors R21 and R22. Therefore, in the state where the control signal indicates the turned on (closed) state of the switch 200 and the transistor M1 is turned on, if the output voltage of the battery module 300 is lower than the threshold value, the comparator U1 may output the signal (the activation signal) of high level. After that, the comparator U1 maintains the output of the activation signal until the control signal indicates the turned off (opened) state of the switch 200, and if the control signal indicates the turned off (opened) state of the switch 200, it may output the signal (the deactivation signal) of low level.

The off circuit 124 may include a transistor Q1.

The transistor Q1 may include a first terminal connected to the input terminal of the switch driver 130, a second terminal connected to the ground, and a control terminal connected to the output terminal of the comparator U1. The off circuit 124 may further include resistors R41, R42, and R43 connected to the control terminal of the transistor Q1 for the stable operation of the transistor Q1.

The transistor Q1 may be turned on if the activation signal is received from the comparator U1 and turned off if the deactivation signal is received from the comparator U1. For example, the transistor Q1 may be an NPN transistor in which a control terminal is a base terminal, and a first terminal and a second terminal are a collector terminal and an emitter terminal, respectively. In this case, the transistor Q1 may be turned on if the activation signal of high level is input, and turned off if the deactivation signal of low level is input. If the transistor Q1 is turned on, it may output the off signal corresponding to the ground voltage to the switch driver 130 by connecting the input terminal of the switch driver 130 to the ground.

The switch control device 100 may further include a resistor R1 connected between the output terminal of the controller 110 and the switch driver 130. Therefore, if the off signal of low level is output from the off circuit 124 to the switch driver 130, even if the controller 110 outputs the control signal of high level, the switch driver 130 may operate the switch 200 in the turned off (opened) state.

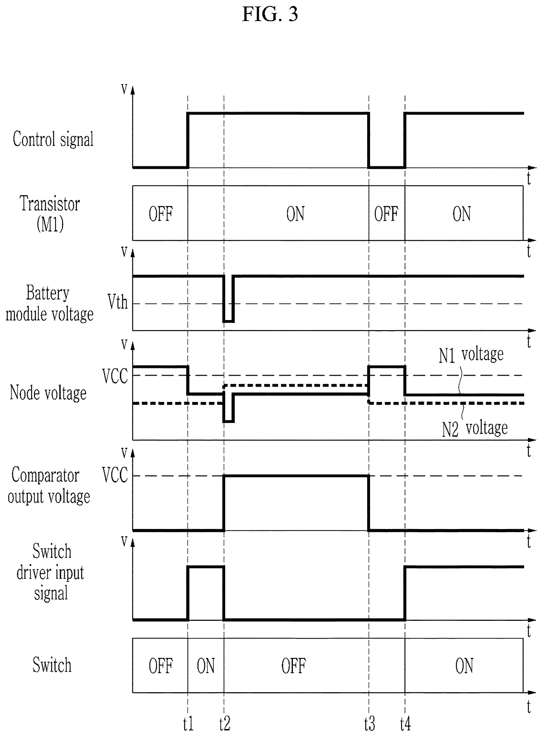

Hereinafter, the operation of the switch control device 100 according to an embodiment will be described in more detail with reference to FIG. 3.

FIG. 3 is a view schematically showing an operation timing diagram of the switch control device 100 according to an embodiment.

Referring to FIG. 3, as the control signal of the low level indicating the turned off (opened) state of the switch 200 is output from the controller 110 until a time t1, the transistor M1 of the comparison voltage generation circuit 121 becomes the turned off state, and thus, the second comparison voltage higher than the voltage of the second power node, VCC, may be applied to the node N1 by the diode D1. In addition, a voltage distributed from the voltage of the second power node, VCC, is applied to the node N2, and the comparator U1 may output the output signal (the inactive signal) of low level. Accordingly, since the controller 110 has the right to control the switch 200, the switch 200 may be controlled in the turned off (opened) state in response to the control signal.

Then, as the control signal of high level indicating the turned on (closed) state of the switch 200 is output from the controller 110 at the time t1, the transistor M1 of the comparison voltage generation circuit 121 is turned on, and as a result, the first comparison voltage distributed from the output voltage of the battery module 300 may be applied to the node N1. While the voltage of the battery module 300 is higher than the threshold value (Vth), the first comparison voltage is higher than the reference voltage applied to the node N2, so the comparator U1 may output the output signal of low level (the inactive signal). Accordingly, since the controller 110 has the right to control the switch 200, the switch 200 may be controlled in the turned on (closed) state in response to the control signal.

On the other hand, at the time t2, a transient situation in which the voltage of the battery module 300 drops below the threshold value (Vth) and returns again occurs, as a result, the first comparison voltage applied to the node N1 may be momentarily lower than the reference voltage applied to the node N2. Therefore, the comparator U1 outputs the output signal (activation signal) of high level, and then the high level output of the comparator U1 may be continued by the diode D2. Accordingly, by activating the off circuit 124 and bringing the control right of the switch 200, the switch 200 may be controlled in a turned off (opened) state.

The activation signal output of the comparator U1 may continue until the control signal of low level indicating the turned off (opened) state of the switch 200 is output from the controller 110 at a time t3. Therefore, the control right of the switch 200 may also be in the off circuit 124, not the controller 110, until the time t3.

At the time t3, if the control signal of low level indicating the turned off (opened) state of the switch 200 is output from the controller 110, the second comparison voltage higher than the voltage of the second power node, VCC, is applied to the node N1 by the diode D1, thereby the comparator U1 may output the output signal of low level (the inactive signal). Therefore, the control right of the switch 200 passes to the controller 110, and the opening/closing of the switch 200 may be controlled in response to the control signal. For example, at the time of t4, the controller 110 may control the switch 200 in the turned on (closed) state by outputting the control signal of high level.

According to the above-described, the switch control device 100, if the transient situation in which the voltage of the battery module 300 is momentarily lowered and then returns to the original state occurs while the controller 110 controls the switch 200 to be turned on (closed), may prevent the switch 200 from being turned on (closed) again by taking the control right of the switch 200 from the controller 110. Therefore, it is possible to prevent the switch 200 from unintentionally repeating the on/off state, thereby preventing a contact welding of the switch 200.

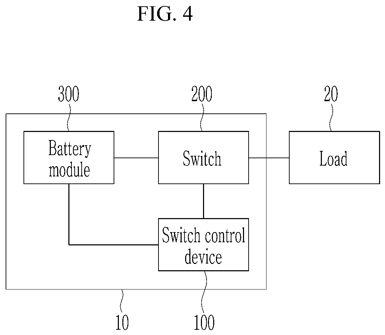

FIG. 4 is a view schematically showing a battery pack including a switch control device according to an embodiment.

Referring to FIG. 4, a battery pack 10 may include a switch control device 100, a switch 200, and a battery module 300.

The battery module 300 may include at least one cell connected in series or in parallel to each other.

The switch 200 may be connected between the battery module 300 and the load 20 to electrically connect the battery module 300 and the load 20 or cut off the electrical connection between the battery module 300 and the load 20.

The switch control device 100 may control the opening/closing state of the switch 200. The switch control device 100, as described with reference to FIG. 1 and FIG. 2, may include the controller 110, the low voltage protective circuit 120, and the switch driver 130.

The controller 110 of the switch control device 100 may be a battery management system (BMS) of the battery pack 10. In this case, the controller 110 determines whether to open/close the switch 200 based on a status information of the battery module 300, a status information of the system (e.g., vehicle) equipped with the battery pack 10, a driving mode, etc., and may output the control signal to control the switch 200.

The drawings referred and the detailed description of the present invention disclosed above are just used for the purpose of describing the present invention, but not used for limiting a meaning or restricting the scope of the present invention disclosed in the claims. Therefore, it will be appreciated by those skilled in the art that various modifications and other embodiments equivalent thereto can be made therefrom. Accordingly, the true technical scope of the present invention should be defined by the appended claims.

### <Description of symbols>

10: battery pack
20: load
100: switch control device
110: controller
120: low voltage protective circuit
121: comparison voltage generation circuit
122: reference voltage generation circuit
123: comparison circuit
124: off circuit
130: switch driver
200: switch
300: battery module

## Claims

1. A switch control device comprising:
a controller configured to output a control signal to control an opening/closing of a switch;
a low voltage protective circuit configured to generate an off signal indicating an opening state of the switch when a voltage of a battery module is lower than a predetermined value in a state that the control signal indicates a closing state of the switch, and to maintain an output of the off signal until the control signal indicates the opening state of the switch; and
a switch driver configured to control the opening/closing of the switch according to the control signal and the off signal, and to control the switch in the opening state regardless of the control signal when the off signal is received from the low voltage protective circuit.

2. The switch control device of claim 1, wherein:
the low voltage protective circuit is further configured to block the output of the off signal when the control signal indicates the opening state of the switch.

3. The switch control device of claim 1 or claim 2, wherein:
the low voltage protective circuit includes
a comparison voltage generation circuit configured to supply one of a first comparison voltage corresponding to the voltage of the battery module and a second comparison voltage that maintains a fixed value regardless of the voltage of the battery module to a first node depending on the control signal;
a reference voltage generation circuit configured to supply a reference voltage to a second node; and
a comparison circuit configured to control the output of the off signal according to a result of comparing a voltage of the first node and the voltage of the second node.

4. The switch control device of claim 3, wherein:
the comparison voltage generation circuit is further configured to supply the first comparison voltage to the first node when the control signal indicates the closing state of the switch, and to supply the second comparison voltage to the first node when the control signal indicates the opening state of the switch,
the second comparison voltage is higher than the reference voltage, and
the first comparison voltage is lower than the reference voltage when the voltage of the battery module is lower than the predetermined value, and higher than the reference voltage when the voltage of the battery module is higher than the predetermined value.

5. The switch control device of claim 3 or claim 4, wherein:
the comparison circuit is further configured to control the off signal to be output to the switch driver when the first comparison voltage is lower than the reference voltage while the first comparison voltage is being supplied to the first node, and to maintain the output of the off signal until the second comparison voltage is supplied to the first node.

6. The switch control device of claim 5, wherein:
the comparison circuit is further configured to block the output of the off signal while the second comparison voltage is supplied to the first node.

7. The switch control device of claim 5 or claim 6, wherein:
the comparison circuit is further configured:
to output an activation signal of high level so as to output the off signal when the first comparison voltage is lower than the reference voltage while the first comparison voltage is supplied to the first node;
to output a deactivation signal of low level so as to block the output of the off signal when the first comparison voltage is supplied to the first node, the first comparison voltage is higher than the reference voltage, and before the activation signal is output; and
to output the deactivation signal so as to block the output of the off signal when the second comparison voltage is supplied to the first node.

8. The switch control device of claim 7, wherein:
the comparison circuit is further configured to transmit a voltage generated from the output of the comparison circuit to the second node, and
the comparison circuit is configured to output the activation signal, such that the voltage transmitted from the output of the comparison circuit to the second node is higher than the first comparison voltage and lower than the second comparison voltage.

9. The switch control device of any of claims 3 to 8, wherein:
the comparison voltage generation circuit includes
a first transistor including a first terminal, a second terminal connected to a ground, and a control terminal to which a control signal is applied,
a first resistor connected between a first power node to which the voltage of the battery module is applied and the first node; and
a second resistor connected between the first node and the first terminal of the first transistor, wherein the switch control device is configured such that:
the first transistor is turned off when the control signal indicates the opening state of the switch, and turned on when the control signal indicates the closing state of the switch, and
when the first transistor is turned on, the first comparison voltage distributed from the voltage of the battery module by the first and second resistors is supplied to the first node.

10. The switch control device of claim 9, wherein:
the comparison voltage generation circuit further includes
a first diode including an anode connected to the first node and a cathode connected to a second power node,
when the first transistor is turned off, the second comparison voltage is supplied to the first node by the first diode,
the second comparison voltage is the voltage clamped from the voltage of the second power node by the first diode and higher than the first comparison voltage, wherein, optionally,
the first transistor is an N-channel MOSFET(Metal Oxide Semiconductor Field Effect Transistor).

11. The switch control device of any of claims 3 to 10, wherein:
the reference voltage generation circuit includes
a third resistor connected between the second power node and the second node, and
a fourth resistor connected between the second power node and a ground.

12. The switch control device of any of claims 3 to 11, wherein:
the comparison circuit includes
a comparator including input terminals respectively connected to the first node and the second node, and an output terminal configured to output an output signal corresponding to a result of comparing the voltage of the first node and the voltage of the second node, and
a second diode including an anode connected to the output terminal of the comparator and a cathode connected to the second node,
wherein the comparison circuit is configured to transfer a voltage generated from the output signal of high level to the second node through the second diode, when the output signal of high level is output to the output terminal of the comparator and
the voltage generated from the output signal of high level is higher than the first comparison voltage and the reference voltage, and lower than the second comparison voltage.

13. The switch control device of any of claims 3 to 13, wherein:
the low voltage protective circuit further includes
an off circuit configured to output the off signal to the switch driver according to the output signal of the comparison circuit, wherein, optionally:
the off circuit includes
a second transistor including a control terminal configured to receive the output signal of the comparator as an input, a first terminal connected to an input terminal of the switch driver, and a second terminal connected to a ground,
wherein the second transistor connects the ground and the input terminal of the switch driver so that the off signal is transmitted to the input terminal of the switch driver during a turning-on, and wherein, optionally,
the second transistor is an NPN transistor.

14. The switch control device of claim 13, further comprising:
a fifth resistor connected between on output terminal of the controller and the input terminal of the switch driver.

15. A battery pack comprising:
a battery module;
a switch configured to control an electrical connection between the battery module and a load; and
the switch control device of any one of claim 1 to claim 14,
wherein opening and closing of the switch is controlled by the switch control device.
